# EUROPEAN PATENT SPECIFICATION

(11) **EP 2 333 824 B1**
(45) Date of publication and mention of the grant of the patent: **16.04.2014**
(21) Application number: 09290931.6
(22) Date of filing: 11.12.2009
(51) Int. Cl.: H01L 21/762

(54) **Manufacture of thin SOI devices**
Herstellung von dünnen SOI-Vorrichtungen
Fabrication de dispositifs SOI mince

(43) Date of publication of application: 15.06.2011
(73) Proprietor: Soitec, 38190 Bernin (FR)
(72) Inventor: Daval, Nicolas, Pleasantville, NY 10570 (US); Aulnette, Cécile, Guilderland, NY 12084 (US)
(74) Representative: Grünecker, Kinkeldey, Stockmair & Schwanhäusser

(56) References cited:
- US-A- 5 013 681
- US-A1- 2005 170 611
- US-B1- 6 323 108

## Description

### Field of Invention

The present invention relates to the manufacture of thin SOl devices and, particularly, the manufacture of double BOX structures by improved etch stop techniques.

### Background of the invention

Fully depleted SOl devices are promising candidates in the future CMOS technology for the solution of the problem of the variability of the threshold voltage caused by random channel doping and short channel effects. These problems represent severe obstacles for further down-scaling. Alternative approaches comprise FinFET devices as well as Extremely Thin SOl (ETSOI) devices. The present invention relates to the improvement of the manufacture of the latter ones.

In US 5 013 681 A, a process for fabricating thin film silicon wafers is described using an etch stop composed of a silicon germanium alloy by growing a strained Si₁₋ₓFeₓ alloy layer onto a seed wafer to serve as an etch stop. In one embodiment, the strained silicon germanium alloy is formed as a second etch stop layer on top of a first etch stop layer comprising boron ions. The silicon of the seed wafer, as well as the first and second etch stop layers may be removed selectively.

In US 6 323 108 B1, the fabrication of an ultra thin bonded semiconductor layer structure is described wherein an epitaxial layer is grown on an etch stop layer formed on a donator substrate. Hydrogen is implanted into the donator substrate to facilitate splitting along the accordingly formed cleavage line defined by the hydrogen implant peak during wafer transfer.

Currently, the vast majority of ETSOI wafers are manufactured using the Smart Cut® process. Those wafers are used to make chips with transistors operating in fully depleted mode. The uniformity of the thin silicon films is crucial for the performance of the resulting ETSOI devices. In order to achieve a satisfying uniformity of a thin silicon film an etch stop layer is deposited on a donor wafer and the thin silicon film is grown atop of the etch stop layer. During the wafer transfer process the donor-wafer is bonded to a target wafer, for example, by a buried layer, particularly a buried oxide layer (BOX). Detachment is achieved either by splitting initiated in the silicon substrate of the donor wafer or splitting initiated in the etch stop layer. In the former case, remaining silicon above the etch stop layer is to be removed and subsequently the etch stop layer is also to be removed. When splitting is performed in the etch stop layer the step of removal of remaining silicon from the donor wafer is avoided.

If a boron-doped etch stop layer is provided, a sufficiently thick etch stop layer that allows for accurate control of the splitting initiated in the etch stop layer can readily be achieved. However, direct contact of the thin silicon film to a boron-doped etch stop layer results in some diffusion of the boron dopants into the thin silicon film thereby deteriorating the quality of the ETSOI configuration. On the other hand, if an SiGe layer is used as the etch stop layer, relaxation defects pose a severe problem for a thickness of the SiGe layer that would allow for splitting initiated in the SiGe etch stop layer. This is due to the fact that a relatively high Ge concentration is needed to provide for a sufficiently high etching selectivity. Thus, in this case splitting has to be performed in the bulk substrate of the donor wafer and the above-mentioned step of removal of silicon material remaining on the surface of the etch stop layer after the detachment cannot be avoided. What is more, etching of the remaining silicon necessarily results is some under-etching of the thin silicon film at edges of and under the etch stop layer transferred to the target substrate.

In view of the above, it is an object of the present invention to provide a method for the manufacture of thin SOl devices wherein the etching problem is alleviated.

### Description of the Invention

The above-mentioned object is addressed by the herein discloses method for the manufacture of an SOl device (structure, wafer) with a thin silicon film. According to claim 1 it is provided a method comprising
forming a structure (configuration) by steps comprising
a) forming a first etch stop layer on a donor substrate;
b) forming a second etch stop layer on the first etch stop layer, wherein the material of the second etch stop layer differs from the material of the first etch stop layer; and the thickness of the second etch stop layer is lower than the thickness of the first etch stop layer;
c) forming a thin silicon film on the second etch stop layer;
and
bonding the structure (configuration) to a target substrate; and
detaching the donor substrate by splitting initiated in the first etch stop layer (i.e. the first etch stop layer splits into two parts one of which maintains attached with the second etch stop layer whereas the other one maintains attached with the donor substrate).

Contrary to the art according to the present invention two different etch stop layers are provided and the silicon film is grown atop of one of these etch stop layers that provide etching selectivity with respect to the thin silicon layer. Accordingly, one of the etch stop layers (the lower one with respect of the thin silicon film) is used for splitting after bonding of the stack comprising the donor substrate, the etch stop layers and the thin silicon film to a target substrate (wafer). This (first) etch stop layer used for the splitting advantageously includes boron and can be readily formed (grown/deposited) to a thickness that allows for an accurately controllable splitting. The silicon film qualifies to be characterized as thin by having a thickness of at most 20 nm, particularly, at most 15 nm, more particularly at most 10 nm. The step of bonding the structure (configuration) to the target substrate may be performed in a conventional manner and may include some heat treatment as known in the art.

The first etch stop layer can be a boron doped silicon layer. The other (second) etch stop layer is advantageously free of any dopants that could be accepted by the thin silicon layer. The second etch stop layer can be an SiGe layer that may comprise at least 15 %, preferably, at least 20 % or 25 % Ge, for example. The second etch stop layer that serves as a diffusion barrier layer against boron when boron dopants are included in the first etch stop layer is formed with a lower thickness than the first etch stop layer. It should be noted that if the first etch stop layer is a boron doped silicon layer, it can be removed (remaining material of this layer can be removed) after wafer transfer by etching by an etchant comprising HF:HNO₃. If the second etch stop layer is an SiGe layer, it can be removed after wafer transfer by etching by an etchant comprising HF:H₂O₂ (HF:H₂O₂:CH₃COOH)

Thus, according to the present invention contamination of the thin silicon layer by dopants, for example, boron dopants, included in the first etch stop layer used for splitting after the bonding process can be avoided. Since the second etch stop layer is not used for the splitting process it can be formed with such a low thickness that relaxation defects after some heat treatment can be avoided.

In addition, both the first and the second etch stop layer exhibit a significant etching selectivity with respect to the silicon of the thin silicon film. Thereby, no under-etching of the thin silicon film is caused during removal of both material of the first etch stop layer remaining atop of the second etch stop layer after splitting and removal of the second etch stop layer after the splitting process performed to provide for a uniform exposed thin silicon film appropriate for the further manufacturing of a thin SOl device (ETSOI device) that might include growing a material layer, etc. The thickness uniformity of the thin silicon layer of the ETSOI wafer is therefore only defined by the thickness uniformity performance of the epitaxy when this layer is grown on the donor substrate.

According to an example the inventive method comprises implanting ions into the first etch stop layer used for the splitting process in order to form a weakened region. In this case, the step of splitting includes splitting at the weakened region by heat treatment. Thereby, detachment of the donor substrate can reliably be controlled. In particular, the splitting process may be carried out within a Smart Cut® process.

The bonding step may be mediated by forming a buried layer, in particular, a buried oxide layer, on the thin silicon film before the bonding step and/or forming a buried layer, in particular, a buried oxide layer, on the target substrate before the bonding step. After formation of the buried (oxide) layer(s) the donor substrate (plus the etch stop layers and the thin silicon layer) are bonded to the target substrate.

In some detail, according to a particular example the inventive method comprises forming a first buried oxide layer on the thin silicon film before the bonding step;
forming a silicon comprising layer comprising boron dopants on the first buried oxide layer before the bonding step;
forming second buried oxide layer on the silicon comprising layer before the bonding step; and
bonding the second buried oxide layer to the target substrate.

Alternatively, in such a configuration bonding can be achieved by
forming a first buried oxide layer on the thin silicon film before the bonding step;
forming a silicon comprising layer comprising boron dopants on the first buried oxide layer before the bonding step;
forming second buried oxide layer on the silicon comprising layer before the bonding step; and
forming a third buried oxide layer on the target substrate.

Subsequently, the second buried oxide layer is bonded to the third buried oxide layer formed on the target substrate.

According to a further alternative the inventive method comprises the steps of
forming a first buried oxide layer on the thin silicon film before the bonding step;
forming a second buried oxide layer on the target substrate before the bonding step;
forming a silicon comprising layer comprising boron dopants on the second buried oxide layer before the bonding step;
forming a third buried oxide layer on the silicon comprising layer before the bonding step; and
bonding the first buried oxide layer to the third buried oxide layer.

After detachment and removal of the remaining material of the first etch stop layer and removal of the second etch stop layer a double BOX structure comprising an exposed thin silicon film results.

The above-mentioned silicon comprising layer provides support for the oxide layer formed thereon and, advantageously, has a work function similar to silicon. Appropriate choices for the silicon comprising layer are amorphous or polycrystalline silicon or amorphous or polycrystalline SiGe, for example.

According to all mentioned alternatives reliable bonding can be achieved that is followed by the step of splitting in the first etch stop layer. Moreover, a boron diffusion barrier layer can be formed directly on the upper and/or lower surface of the silicon comprising layer, i.e. between the silicon comprising layer and the respective buried oxide layers.

By the above-described methods a thin silicon film for the manufacture of ETSOI devices is provided with an unprecedented uniformity for a thickness of the silicon film of at most 20 nm, particularly 10 nm, more particularly, at most 5 nm, for example.

Additional features and advantages of the present invention will be described with reference to the drawings. In the description, reference is made to the accompanying figures that are meant to illustrate preferred embodiments of the invention. It is understood that such embodiments do not represent the full scope of the invention.
Figure 1 illustrates an example of the inventive method including the formation of two etch stop layers and wafer transfer including splitting in one of the etch stop layers.
Figure 2 illustrates another example of the inventive method wherein a double BOX configuration including a thin silicon film is obtained after wafer transfer including splitting in one of the etch stop layers.
Figure 3 illustrates another example of the inventive method wherein a double BOX configuration including a thin silicon film is obtained after wafer transfer including splitting in one of the etch stop layers.

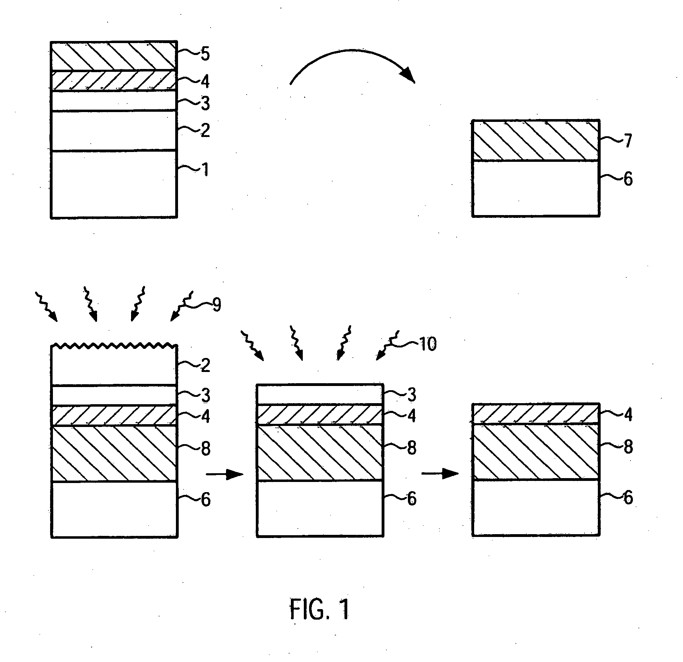

Figure 1 shows an example of the herein disclosed method wherein wafer transfer is mediated by a splitting process that is initiated in one of two provided etch stop layers.
As shown in Figure 1 a first etch stop layer 2 is grown on a donor substrate 1. A second etch stop layer 3 is grown atop of the first etch stop layer 2. The donor substrate 1 may be a common silicon substrate. According to the present example, the first etch stop layer 2 consists of or comprises boron doped silicon and the second etch stop layer 3 consists of or comprises SiGe, particularly, with a Ge content of more than 20 %. The second etch stop layer 3 is sufficiently thin to substantially avoid relaxation defects.

A very thin silicon film 4 is formed on the upper (free) surface of the second etch stop layer 3. it is crucial that this layer is grown as uniform as possible.The thickness of the thin silicon film 4 may lie between some nm and 20 nm, in particular, between 5 nm and 15 nm.

In order to facilitate wafer transfer a buried oxide layer 5 is formed atop of the thin silicon film 4. The resulting structure undergoes a wafer transfer process to a target substrate 6 covered by another buried oxide layer 7. The target substrate 6 may be made of the same material as the donor substrate 1. Detachment is achieved by splitting initiated in the first etch stop layer 2 after the process of bonding of the first 5 and the second 7 buried oxide layers resulting in buried oxide layer 8 has been completed. The splitting may be initiated by any known conventional method comprising, for example, an appropriate heat treatment. For example, the Smart Cut® process may be performed (see also description below). Since splitting is initiated in the first etch stop layer 2, after detachment some material of the first etch stop layer 2 remains atop of the second etch stop layer 3.

In order to achieve a free surface of the thin silicon film 4 that is to be provided for subsequent steps of the manufacture of a semiconductor device, the remaining material of the first etch stop layer 2 is etched in a first etching process 9. This first etching process 9 is advantageously highly selective with respect to the thin silicon film 4 to avoid damages. Removal can be achieved by an etchant comprising HF:HNO₃. After the remaining material of the first etch stop layer 2 has been completely removed a second etching process 10 is performed in order to remove the second etch stop layer 3 from the surface of the thin silicon film 4. The second etching process 10 is highly selectively with respect to the thin silicon film 4. For this, reason a relative high Ge content is provided in the case of a SiGe layer used for the second etch stop layer (see above). Removal of the second etch stop layer 3 can be achieved by an etchant comprising HF:H₂O₂ (HF:H₂O₂:CH₃COOH). After removal of the first etch stop layer 2 the desired ETSOI structure comprising a target substrate 6, the buried oxide layer 8 resulting from bonding of the first 5 and the second 7 buried oxide layers and the thin silicon film 4 is achieved as it is illustrated in Figure 1.

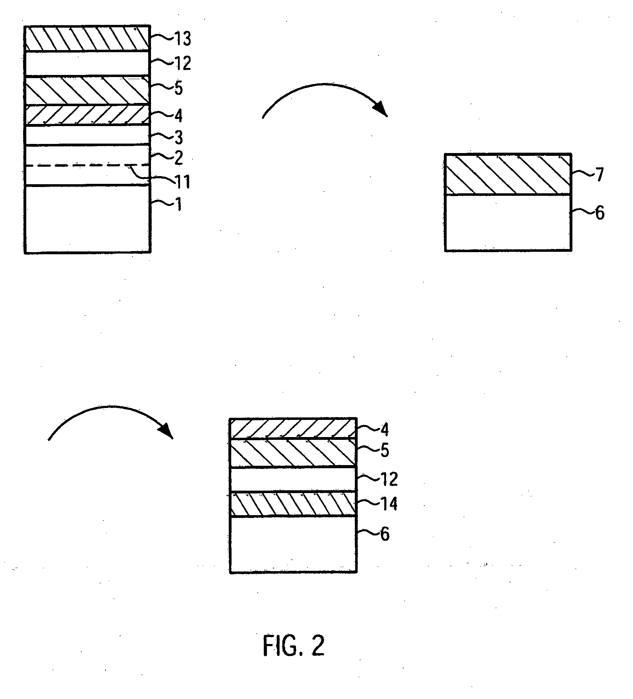

Another example of the inventive method will now be described with reference to Figure 2. Similar to the example shown in Figure 1 a first etch stop layer 2 and a second etch stop layer 3 are formed on a donor substrate 1. In the first etch stop layer 2 a weakened layer 11 is formed by the implantation of ions, for example, hydrogen ions.

A thin silicon film 4 is grown atop of the second etch stop layer 3. A first buried oxide layer 5 is formed atop of the thin silicon film 4. Different from the example shown in Figure 1, the first buried oxide layer 5 is not used for bonding with a second buried oxide layer 7 grown on a target substrate 6. Subsequently, a polycrystalline silicon film 12 doped with boron, for example, with a boron concentration of some 10¹⁸ to some 10¹⁹ cm⁻³, is formed atop of the first buried oxide layer 5. Atop of the polycrystalline silicon film 12 doped with boron a third buried oxide layer 13 is formed to mediate bonding to the second buried oxide layer 7 formed on the target wafer 6. Bonding results in a combined buried oxide layer 14 comprising the bonded buried oxide layers 7 and 13.

Detachment is again achieved by splitting initiated in the first etch stop layer 2. In particular, splitting occurs at the weakened layer 11.

As it is shown in Figure 2 after detachment of the donor substrate 1 and removal of remaining material of the first etch stop layer 2 and complete removal of the second etch stop layer 3 a double BOX configuration comprising the target substrate 6, the combined BOX layer 14, the polycrystalline silicon film 12 doped with boron, the first BOX layer 5 and the thin silicon film 4 in this order is obtained. Both the first box layer 5 and the thin silicon film 4 may have a thickness of some 10 nm, particularly, of 5 nm to 15 nm.

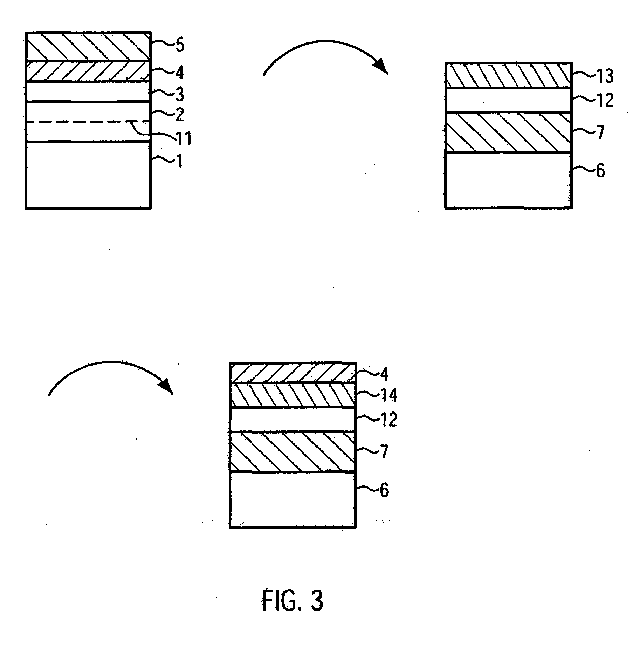

A double BOX configuration can alternatively be obtained as it is illustrated in Figure 3. In this example, layers 12 and 13 of Figure 12 are not formed on the donor wafer, Rather, a polycrystalline silicon film 12 and another buried oxide layer 13 are formed on a buried oxide layer 7 formed on a target substrate 6. After bonding buried oxide layers 5 and 13, detachment by splitting initiated in the first etch stop layer 2 and removal of the remaining material of the first etch stop layer 2 and the second etch stop layer 3 from the thin silicon film 4, a double BOX configuration with the buried oxide layer 7 and the buried oxide layer 14 resulting from bonding of the buried oxide layers 5 and 13 is obtained.

Furthermore, in the examples shown in Figures 2 it might be preferred to form thin interlayer consisting of Si₃N₄ between the buried oxide layer 5 and the polycrystallinesilicon film 12 and the polycrystalline silicon film 12 and the buried oxide layer 13 (Figure 2) or between the buried oxide layer 7 and the polycrystalline silicon film 12 and the polycrystalline silicon film 12 and the buried oxide layer 13 (Figure 3), respectively. Thereby, diffusion of the small boron atoms from the doped polycrystalline silicon film 12 to the buried oxide layers can be prevented.

The resulting structures shown in Figures 1, 2 and 3 can readily be used for microchip manufacture based on ETSOI, in particular, for the manufacture of transistor devices in 22 nm technology and below. Compared to the art an unprecedented uniformity of the thin silicon film can be achieved by the herein disclosed inventive method.

## Claims

1. Method comprising
forming a structure by steps comprising
a) forming a first etch stop layer (2) on a donor substrate (1);
b) forming a second etch stop layer (3) on the first etch stop layer (2), wherein
the material of the second etch stop layer (3) differs from the material of the first etch stop layer (2); and
the thickness of the second etch stop layer (3) is lower than the thickness of the first etch stop layer (2);
c) forming a thin silicon film (4) on the second etch stop layer (3), wherein the first and second etch stop layers provide etching selectivity with respect to the thin silicon layer;
and
bonding the structure to a target substrate (6) by a buried oxide layer; and
detaching the donor substrate (1) by splitting initiated in the first etch stop layer (2).

2. The method according to claim 1, further comprising
removing remaining material of the first etch stop layer (2) from the second etch stop layer (3) after the detachment of the donor substrate (1); and
subsequently removing the second etch stop layer (3).

3. The method according to claim 1 or 2, wherein the first etch stop layer (2) comprises or consists of boron doped silicon.

4. The method according to one of the preceding claims, wherein the second etch stop layer (3) comprises or consists of a SiGe layer.

5. The method according to claim 4, wherein the SiGe layer comprises at least 15 % Ge, in particular, at least 20 % Ge.

6. The method according to one of the preceding claims, further comprising implanting ions into the first etch stop layer (2) in order to form a weakened region (11) and wherein the step of splitting includes splitting at the weakened region (11) by heat treatment.

7. The method according to one of the preceding claims, further comprising forming a buried layer (5), in particular, a buried oxide layer, on the thin silicon film (4) before the bonding step and/or forming a buried layer (7), in particular, a buried oxide layer, on the target substrate (6) before the bonding step and wherein the bonding is facilitated by the buried layer (5) on the thin silicon film (4) and/or the buried layer (7) on the target substrate (6).

8. The method according to one of the claims 1 to 6, further comprising
forming a first buried oxide layer (5) on the thin silicon film (4) before the bonding step;
forming a silicon comprising layer (12) comprising boron dopants on the first buried oxide layer (5) before the bonding step;
forming second buried oxide layer (13) on the silicon comprising layer (12) before the bonding step; and
bonding the second buried oxide layer (13) to the target substrate (6).

9. The method according to one of the claims 1 to 6, further comprising
forming a first buried oxide layer (5) on the thin silicon film (4) before the bonding step;
forming a silicon comprising layer (12) comprising boron dopants on the first buried oxide layer (5) before the bonding step;
forming second buried oxide layer (13) on the silicon comprising layer (12) before the bonding step;
forming a third buried oxide layer (7) on the target substrate (6) before the bonding step; and
bonding the second buried oxide layer (13) to the third buried oxide layer (7) formed on the target substrate (6).

10. The method according to one of the claims 1 to 6, further comprising
forming a first buried oxide layer (5) on the thin silicon film (4) before the bonding step;
forming a second buried oxide layer (7) on the target substrate (6) before the bonding step;
forming a silicon comprising layer (12) comprising boron dopants on the second buried oxide layer (7) before the bonding step;
forming a third buried oxide layer (13) on the silicon comprising layer (12) before the bonding step; and
bonding the first buried oxide layer (5) to the third buried oxide layer (13).

11. The method according to one of the claims 8 to 9, further comprising forming a boron diffusion barrier layer on the first buried oxide layer (5) and/or on the silicon comprising layer (12).

12. The method according to one of the claims 8 to 11, wherein the silicon comprising layer (12) is an amorphous or polycrystalline slicon layer or an amorphous or polycrystalline SiGe layer.

13. The method according to claim 9, further comprising forming a boron diffusion barrier layer on second buried oxide layer (7) and/or on the silicon comprising layer (12).

14. The method according to one of the preceding claims, wherein the thin silicon film (4) is formed at a thickness of at most 10 nm, in particular, at most 5 nm.

## Patentansprüche

1. Verfahren, umfassend:
Bilden einer Struktur durch wenigstens die folgenden Schritte:
a) Bilden einer ersten Ätzstoppschicht (2) auf einem Donator-Substrat (1);
b) Bilden einer zweiten Ätzstoppschicht (3) auf der ersten Ätzstoppschicht (2), wobei
das Material der zweiten Ätzstoppschicht (3) sich von dem Material der ersten Ätzstoppschicht (2) unterscheidet; und
die Dicke der zweiten Ätzstoppschicht (3) geringer als die Dicke der ersten Ätzstoppschicht (2) ist;
c) Bilden eines dünnen Siliziumfilms (4) auf der zweiten Ätzstoppschicht (3), wobei die erste und die zweite Ätzstoppschicht eine Ätzselektivität bezüglich des dünnen Siliziumfilms bereitstellen;
und
Bonden der Struktur an ein Zielsubstrat (6) durch eine eingebettete Oxidschicht; und
Abtrennen des Donator-Substrats (1) durch Spaltung, die in der ersten Ätzstoppschicht (2) eingeleitet wird.

2. Verfahren nach Anspruch 1, ferner umfassend:
Entfernen von Restmaterial der ersten Ätzstoppschicht (2) von der zweiten Ätzstoppschicht (3) nach dem Abtrennen des Donator-Substrats (1); und
anschließendes Entfernen der zweiten Ätzstoppschicht (3).

3. Verfahren nach Anspruch 1 oder 2, wobei die erste Ätzstoppschicht (2) mit Bor dotiertes Silizium aufweist oder daraus besteht.

4. Verfahren nach einem der vorhergehenden Ansprüche, wobei die zweite Ätzstoppschicht (3) eine SiGe-Schicht aufweist oder daraus besteht.

5. Verfahren nach Anspruch 4, wobei die SiGe-Schicht mindestens 15% Ge, insbesondere mindestens 20% Ge, enthält.

6. Verfahren nach einem der vorhergehenden Ansprüche, ferner umfassend das Implantieren von Ionen in die erste Ätzstoppschicht (2), um einen geschwächten Bereich (11) zu bilden, und wobei der Spaltungsschritt eine Spaltung in dem geschwächten Bereich (11) durch Wärmebehandlung umfasst.

7. Verfahren nach einem der vorhergehenden Ansprüche, ferner umfassend das Bilden einer eingebetteten Schicht (5), insbesondere einer eingebetteten Oxidschicht, auf dem dünnen Siliziumfilm (4) vor dem Bondingschritt und / oder das Bilden einer eingebetteten Schicht (7), insbesondere einer eingebetteten Oxidschicht, auf dem Zielsubstrat (6) vor dem Bondingschritt, und wobei das Bonden durch die eingebettete Schicht (5) auf dem dünnen Siliziumfilm (4) und / oder die eingebettete Schicht (7) auf dem Zielsubstrat (6) erleichtert wird.

8. Verfahren nach einem der Ansprüche 1 bis 6, ferner umfassend:
Bilden einer ersten eingebetteten Oxidschicht (5) auf dem dünnen Siliziumfilm (4) vor dem Bondingschritt;
Bilden einer Silizium aufweisenden Schicht (12), die Bordotanden aufweist, auf der ersten eingebetteten Oxidschicht (5) vor dem Bondingschritt;
Bilden einer zweiten eingebetteten Oxidschicht (13) auf der Silizium aufweisenden Schicht (12) vor dem Bondingschritt; und
Bonden der zweiten eingebetteten Oxidschicht (13) an das Zielsubstrat (6).

9. Verfahren nach einem der Ansprüche 1 bis 6, ferner umfassend:
Bilden einer ersten eingebetteten Oxidschicht (5) auf dem dünnen Siliziumfilm (4) vor dem Bondingschritt;
Bilden einer Silizium aufweisenden Schicht (12), die Bordotanden aufweist, auf der ersten eingebetteten Oxidschicht (5) vor dem Bondingschritt;
Bilden einer zweiten eingebetteten Oxidschicht (13) auf der Silizium aufweisenden Schicht (12) vor dem Bondingschritt;
Bilden einer dritten eingebetteten Oxidschicht (7) auf dem Zielsubstrat (6) vor dem Bondingschritt; und
Bonden der zweiten eingebetteten Oxidschicht (13) an die auf dem Zielsubstrat (6) gebildete, dritte eingebettete Oxidschicht (7).

10. Verfahren nach einem der Ansprüche 1 bis 6, ferner umfassend:
Bilden einer ersten eingebetteten Oxidschicht (5) auf dem dünnen Siliziumfilm (4) vor dem Bondingschritt;
Bilden einer zweiten eingebetteten Oxidschicht (7) auf dem Zielsubstrat (6) vor dem Bondingschritt;
Bilden einer Silizium aufweisenden Schicht (12), die Bordotanden aufweist, auf der zweiten eingebetteten Oxidschicht (7) vor dem Bondingschritt;
Bilden einer dritten eingebetteten Oxidschicht (13) auf der Silizium aufweisenden Schicht (12) vor dem Bondingschritt; und
Bonden der ersten eingebetteten Oxidschicht (5) an die dritte eingebettete Oxidschicht (13).

11. Verfahren nach einem der Ansprüche 8 bis 9, ferner die Bildung einer Bordiffusionssperrschicht auf der ersten eingebetteten Oxidschicht (5) und / oder auf der Silizium aufweisenden Schicht (12) umfassend.

12. Verfahren nach einem der Ansprüche 8 bis 11, wobei die Silizium aufweisende Schicht (12) eine amorphe oder polykristalline Siliziumschicht oder eine amorphe oder polykristalline SiGe-Schicht ist.

13. Verfahren nach Anspruch 9, ferner die Bildung einer Bordiffusionssperrschicht auf der zweiten eingebetteten Oxidschicht (7) und / oder auf der Silizium aufweisenden Schicht (12) umfassend.

14. Verfahren nach einem der vorhergehenden Ansprüche, wobei der dünne Silizidmfilm (4) mit einer Dicke von höchstens 10 nm, insbesondere von höchstens 5 nm, ausgebildet ist.

## Revendications

1. Procédé comprenant:
la formation d'une structure par des étapes comprenant
a) former une première couche d'arrêt de gravure (2) sur un substrat donneur (1);
b) former une deuxième couche d'arrêt de gravure (3) sur la première couche d'arrêt de gravure (2), dans laquelle
le matériau de la deuxième couche d'arrêt de gravure (3) est différent du matériau de la première couche d'arrêt de gravure (2); et
l'épaisseur de la deuxième couche d'arrêt de gravure (3) est inférieure à l'épaisseur de la première couche d'arrêt de gravure (2);
c) former un film mince de silicium (4) sur la deuxième couche d'arrêt de gravure (3), dans lequel les première et deuxième couches d'arrêt de gravure offrent une sélectivité d'attaque par rapport au film mince de silicium; et
la liaison de la structure à un substrat cible (6) par une couche d'oxyde enterrée; et
la séparation du substrat donneur (1) par fendage initié dans la première couche d'arrêt de gravure (2).

2. Procédé selon la revendication 1, comprenant en outre
enlever du matériau restant de la première couche d'arrêt de gravure (2) de la deuxième couche d'arrêt de gravure (3) après la séparation du substrat donneur (1); et
enlever ensuite la deuxième couche d'arrêt de gravure (3).

3. Procédé selon la revendication 1 ou 2, dans lequel la première couche d'arrêt de gravure (2) comprend ou est constituée de silicium dopé au bore.

4. Procédé selon l'une quelconque des revendications précédentes, dans lequel la deuxième couche d'arrêt de gravure (3) comprend ou est constituée d'une couche de SiGe.

5. Procédé selon la revendication 4, dans lequel la couche de SiGe comprend au moins 15% de Ge, en particulier, au moins 20% de Ge.

6. Procédé selon l'une quelconque des revendications précédentes, comprenant en outre l'implantation d'ions dans la première couche d'arrêt de gravure (2) afin de former une région affaiblie (11) et dans lequel l'étape de fendage comprend le fendage de la région affaiblie (11) par un traitement thermique.

7. Procédé selon l'une quelconque des revendications précédentes, comprenant en outre la formation d'une couche enterrée (5), en particulier, d'une couche d'oxyde enterrée, sur le film mince de silicium (4) avant l'étape de liaison et / ou la formation d'une couche enterrée (7), en particulier, d'une couche d'oxyde enterrée, sur le substrat cible (6) avant l'étape de liaison et dans lequel la liaison est facilitée par la couche enterrée (5) sur le film mince de silicium (4) et / ou par la couche enterrée (7) sur le substrat cible (6).

8. Procédé selon l'une quelconque des revendications 1 à 6, comprenant en outre
former une première couche d'oxyde enterrée (5) sur le film mince de silicium (4) avant l'étape de liaison;
former une couche (12) comprenant du silicium et contenant des dopants de bore sur la première couche d'oxyde enterrée (5) avant l'étape de liaison;
former une deuxième couche d'oxyde enterré (13) sur la couche (12) comprenant du silicium avant l'étape de liaison; et
relier la deuxième couche d'oxyde enterrée (13) au substrat cible (6).

9. Procédé selon l'une quelconque des revendications 1 à 6, comprenant en outre
former une première couche d'oxyde enterrée (5) sur le film mince de silicium (4) avant l'étape de liaison;
former une couche (12) comprenant du silicium et contenant des dopants de bore sur la première couche d'oxyde enterrée (5) avant l'étape de liaison;
former une deuxième couche d'oxyde enterrée (13) sur la couche (12) comprenant du silicium avant l'étape de liaison;
former une troisième couche d'oxyde enterrée (7) sur le substrat cible (6) avant l'étape de liaison; et
relier la deuxième couche d'oxyde enterrée (13) à la troisième couche d'oxyde enterrée (7) formée sur le substrat cible (6).

10. Procédé selon l'une quelconque des revendications 1 à 6, comprenant en outre
former une première couche d'oxyde enterrée (5) sur le film mince de silicium (4) avant l'étape de liaison;
former une deuxième couche d'oxyde enterrée (7) sur le substrat cible (6) avant l'étape de liaison;
former une couche (12) comprenant du silicium et contenant des dopants de bore sur la deuxième couche d'oxyde enterrée (7) avant l'étape de liaison;
former une troisième couche d'oxyde enterrée (13) sur la couche (12) comprenant du silicium avant l'étape de liaison; et
relier la première couche d'oxyde enterrée (5) à la troisième couche d'oxyde enterrée (13).

11. Procédé selon l'une quelconque des revendications 8 à 9, comprenant en outre la formation d'une couche de barrière de diffusion de bore sur la première couche d'oxyde enterrée (5) et / ou sur la couche (12) comprenant du silicium.

12. Procédé selon l'une quelconque des revendications 8 à 11, dans lequel la couche (12) comprenant du silicium est une couche de silicium amorphe ou polycristallin ou une couche de SiGe amorphe ou polycristallin.

13. Procédé selon la revendication 9, comprenant en outre la formation d'une couche de barrière de diffusion de bore sur la deuxième couche d'oxyde enterrée (7) et / ou sur la couche (12) comprenant du silicium.

14. Procédé selon l'une quelconque des revendications précédentes, dans lequel le film mince de silicium (4) est formé à une épaisseur d'au plus 10 nm, en particulier, d'au plus 5 nm.
